(19) Europäisches Patentamt
European Patent Office
Office européen des brevets

(11) **EP 3 564 933 B1**

(12) # EUROPEAN PATENT SPECIFICATION

(45) Date of publication and mention
of the grant of the patent:
**11.06.2025 Bulletin 2025/24**

(21) Application number: **18859516.9**

(22) Date of filing: **30.05.2018**

(51) International Patent Classification (IPC):
**G02F 1/13** *(2006.01)*     **G02F 1/1339** *(2006.01)*
**G09F 9/00** *(2006.01)*

(52) Cooperative Patent Classification (CPC):
**G02F 1/1303; G02F 1/1339; G09F 9/00;**
G02F 1/13398

(86) International application number:
**PCT/CN2018/089083**

(87) International publication number:
**WO 2019/056792 (28.03.2019 Gazette 2019/13)**

(54) **PACKAGED MASK PLATE, PACKAGING METHOD AND DISPLAY PANEL**

VERPACKTE MASKENPLATTE, VERPACKUNGSVERFAHREN UND ANZEIGETAFEL

PLAQUE DE MASQUE EMBALLÉE, PROCÉDÉ D'EMBALLAGE ET PANNEAU D'AFFICHAGE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **25.09.2017 CN 201710874960**

(43) Date of publication of application:
**06.11.2019 Bulletin 2019/45**

(73) Proprietor: **Kunshan Go-Visionox Opto-
Electronics Co., Ltd.**
**KunShan City, Jiangsu 215300 (CN)**

(72) Inventor: **ZOU, Min**
**Kunshan**
**Jiangsu 215300 (CN)**

(74) Representative: **D'Halleweyn, Nele Veerle Trees
Gertrudis**
**Arnold & Siedsma**
**Bezuidenhoutseweg 57**
**2594 AC The Hague (NL)**

(56) References cited:
CN-A- 104 651 778      CN-A- 106 494 066
CN-A- 107 088 505      CN-A- 107 088 505
CN-A- 107 742 472      CN-U- 204 833 221
CN-U- 206 301 119      US-A1- 2011 128 493
US-A1- 2015 131 044

## Description

### TECHNICAL FIELD

The present disclosure relates to the field of display device technologies, and more particularly relates to package masks, packaging methods, and display panels.

### BACKGROUND TECHNOLOGY

Conventionally, a display panel is packaged with glass cement. The glass cement is coated/printed on an edge of one of the substrates according to a designed width to form a package adhesive line. And then, the other substrate is packaged with the previous substrate by the package adhesive line to protect electronic components located between the two substrates.

In an actual production process, a height of the manufactured package adhesive line may deviate from a designed height, resulting in height deviations of the different package adhesive lines at four edges of the substrate, ultimately resulting in inconsistent heights of the package adhesive line at the four edges. In this way, an interval between the two substrates after packaging is inconsistent everywhere, which causes the display panel to have a Newton ring phenomenon and affects the quality of the product.

US 2011/128493 A1 discloses a flat panel display including a first substrate, a second substrate, a light emitting region between the first and second substrates, and a sealant applied outside of the light emitting region, wherein the sealant has a rectangular shape and includes a first sealing part and a third sealing part opposite each other, and a second sealing part and a fourth sealing part opposite each other, the first, second, third, and fourth sealing parts being interconnected, and wherein the flat panel display includes a compensating part corresponding to at least one of the first, second, third, and fourth sealing parts on or in the first or second substrate.

CN 106 494 066 discloses a making method of a silk-printing screen plate, comprising the following steps: providing a screen frame with a silk screen; coating the silk screen with screen paste, so that an adhesive application area and a non-adhesive-application area are obtained, and the non-adhesive-application area is covered with the screen paste; and coating one side of the silk screen obtained in the previous step with the screen paste, so that an uplifted area surrounding the adhesive application area is obtained, and the uplifted area is covered with the screen paste.

US 2015/0131044 A1 discloses a display apparatus including a first substrate including a display area in which a plurality of pixels is disposed and a non-display area disposed adjacent to the display area, a second substrate which faces the first substrate, an image display layer between the first substrate and the second substrate, and a sealing member which is in the non-display area and attaches the first substrate and the second substrate. The first and second substrates have a curved surface in a first direction, and a flat surface in a second direction crossing the first direction A width of the sealing member extended in the first direction is greater than a width of the sealing member extended in the second direction.

### SUMMARY

Accordingly, it is necessary to provide a package mask, a packaging method, and a display panel to solve the problem that the display panel generates a Newton ring phenomenon caused by deviations between a height of a package adhesive line and a designed height having a different tendency when the glass cement is used for packaging.

The invention is defined by the appended claims. A package mask provided by the present disclosure includes a main body and a package slit group defined on the main body. The package slit group includes a first slit group extending along a first direction and a second slit group extending along a second direction. The first slit group and the second slit group are in communication with each other and are formed as an enclosed regular quadrangle. The first slit group includes at least two first slits each for manufacturing a first package adhesive line, and the second slit group includes at least two second slits each for manufacturing a second package adhesive line. A width of each of the first slits along the second direction is greater than a width of each of the second slits along the first direction. The first direction is the same as a printing direction in which a packaging material is printed onto the package mask.

In an embodiment, a ratio of the width of each of the first slits along the second direction to the width of each of the second slits along the first direction ranges from 1.15:1 to 1.25:1.

In an embodiment, the width of each of the first slits along the second direction ranges from 300 $\mu$m to 700 $\mu$m, the width of each of the second slits along the first direction ranges from 240 $\mu$m to 609 $\mu$m.

The present disclosure further provides a packaging method, which provides a package area by using the aforementioned mask.

In an embodiment, a used packaging material is glass cement.

The present disclosure further provides a display panel, which is manufactured by using the aforementioned packaging method.

In an embodiment, a uniformity between a height of the first package adhesive line and a height of the second package adhesive line is less than 5%.

In an embodiment, the height of the first package adhesive line and the height of the second package adhesive line ranges from 5.2 $\mu$m to 5.7 $\mu$m.

The aforementioned package mask includes the main body and the package slit group formed through the main body. The package slit group includes the first slit group extending along the first direction and the second slit group extending along the second direction. The first slit group includes at least two first slits, and the second slit group includes at least two second slits. By configuring the width of each of the first slits along the second direction greater than the width of each of the second slits along the first direction, when a packaging material is printed onto the substrate along the first direction by a material scraper, the second slits can be made to have a smaller amount of ink permeation with respect to the first slits. The smaller amount of ink permeation can reduce a contact area with the material scraper, thereby reducing the pressure of the material scraper. Therefore, the uniformity between the height of the second package adhesive line formed according to the second slit and the height of the first package adhesive line formed according to the first slit can be improved, so that the interval between the two substrates of the display panel after packaging is equal everywhere, thereby avoiding the generation of Newton's ring and improving the quality of the display panel.

A package method provided by the present disclosure comprises providing a package area by using a package mask of any one of the aforementioned embodiments, forming a first package adhesive line corresponding to the first slit group, and forming a second package adhesive line corresponding to the second slit group. The forming the first package adhesive line corresponding to the first slit group and the forming the second package adhesive line corresponding to the second slit group comprises providing a first substrate, disposing the package mask on the first substrate, coating a package adhesive in the first slit group and the second slit group, and operating a material scraper along the first direction on a surface of the mask to remove an excess package adhesive.

A display panel manufactured by using the aforementioned packaging method is also provided by the present disclosure.

## BRIEF DESCRIPTION OF THE DRAWINGS

To illustrate the technical solutions according to the embodiments of the present disclosure or in the prior art more clearly, the accompanying drawings for describing the embodiments or the prior art are introduced briefly in the following. Apparently, the accompanying drawings in the following description are only some embodiments of the present disclosure, and persons of ordinary skill in the art can derive other drawings from the accompanying drawings without creative efforts.

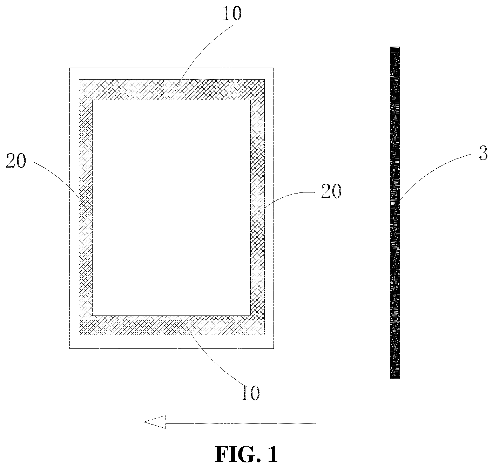

FIG. 1 is a schematic view of a package mask and a traveling direction of a material scraper according to an embodiment of the present disclosure.

## DETAILED DESCRIPTION OF THE EMBODIMENTS

In order to make the objective, technical solutions and advantages of the present disclosure more clear, the package mask, the packaging method, and a display panel of the present disclosure will be further described in detail below with reference to the accompanying drawings and embodiments. It is understood that the specific embodiments described herein are merely illustrative of the application and are not intended to be limiting.

Conventionally, display panels tend to produce Newton rings. For example, an in-plane switching panel (IPS panel) is packaged by glass cement, and the glass cement is printed on four edges of the first substrate according to a designed width to form a package adhesive line. The designed width is determined by a width of a slit of the mask, so that four package adhesive lines are formed on the four edges of the first substrate, respectively, and the first substrate and the second substrate are packaged together by using the four glass adhesive lines. However, a Newton's ring phenomenon is often generated between the first substrate and the second substrate, which affects the packaging effect of the display panel. The inventors of the present disclosure have found that, in the display panel manufactured by using the aforementioned scheme, the final heights of the four package adhesive lines are inconsistent, causing an interval between the first substrate and the second substrate after packaging to be different everywhere, resulting in a Newton's ring phenomenon.

There is a deviation between the final width of the four package adhesive lines and the designed width, and the tendency of the deviation is inconsistent. Even if the designed widths of the four package adhesive lines are same, the deviation tendency of the final widths of the four package adhesive lines after printing with a mask is also different.

Referring to FIG. 1, the present disclosure provides a package mask including a main body and a package slit group defined on the main body. The package slit group includes a first slit group extending along a first direction and a second slit group extending along a second direction. The first slit group includes at least two first slits 10, and the second slit group includes at least two second slits 20. A width of each of the first slits 10 along the second direction is greater than a width of each of the second slits 20 along the first direction. When this package mask is used for packaging, a first package adhesive line is provided corresponding to the first slit 10, and a second package adhesive line is provided corresponding to the second slit 20. The main body can be of a plate shape.

By configuring the width of each of the first slits 10 along the second direction greater than the width of each of the second slits 20 along the first direction, when the packaging material is printed onto the substrate along the first direction by a material scraper 3, the second slits 20 can be made to have a smaller amount of ink permeation with respect to the first slits 10. The smaller amount of ink permeation can reduce the contact area with the material scraper 3, thereby reducing the pressure of the material scraper 3. Therefore, the uniformity between the height of the second package adhesive line formed according to the second slit 20 and the height of the first package adhesive line formed according to the first slit 10 can be improved, so that the interval between the two substrates of the display panel after packaging is equal everywhere, thereby avoiding the generation of Newton's ring and improving the quality of the display panel.

The first slit group and the second slit group are in communication with each other. The plurality of first slits 10 included in the first slit group and the plurality of second slits 20 included in the second slit group intersect and are in communication with each other to form a mesh structure on the mask. A shape of the mesh structure is configured according to packaging requirements so as to form a mesh-connected package adhesive line via the mask.

The first slit group and the second package slit group form an enclosed regular quadrangle so as to form an enclosed regular quadrangular adhesive line on the substrate.

Referring to FIG. 1, a mask having an enclosed regular quadrangle of a printed structural unit is shown. A direction of an arrow indicates a printing direction of the material scraper 3. The printing direction is same as the first direction.

The process of printing the glass cement on the substrate is introduced below. The mask is disposed on the substrate, the package adhesive is coated in the first slit group and the second slit group, and then the material scraper 3 is operated along the first direction on a surface of the mask, the package adhesive is pressed into the first slit 10 of the first slit group and the second slit 20 of the second slit group while excess package adhesive is scraped off. Therefore, an end-to-end package adhesive line is formed in the first slit group and the second slit group of the mask of one package structure unit. The first package adhesive line is manufactured according to the first slit 10, and the second package adhesive line is manufactured according to the second slit 20.

The printing processes of the first package adhesive line and the second package adhesive line are compared. During the operation of the material scraper 3 along the first direction, a contact area of the material scraper 3 in contact with the first slit 10 is less than a contact area of the material scraper 3 in contact with the second slit 20, the pressure of the package adhesive in the first slit 10 by the material scraper 3 is also relatively small, with respect to that in the second slit 20. Therefore, a value of the final width of the first package adhesive line deviates from the width of the first slit 10 along the second direction is less than that of the final width of the second package adhesive line deviates from the width of the second slit 20 along the first direction. A final height of the first package adhesive line is higher than a final height of the second package adhesive line. In the present disclosure, by configuring the area per unit length of the first slit group greater than the area per unit length of the second slit group, the contact area of the first slit 10 in contact with the material scraper 3 can be increased for compensating the difference of the contact area of the first slit 10 extending along the first direction in contact with the material scraper 3 from the contact area of the second slit 20 extending along the second direction in contact with the material scraper 3. Therefore, the amount of ink permeation in the first slit 10 can be increased, that is, the amount of the package adhesive entering the first slit 10 is increased, thereby the pressure of the package adhesive entering the first slit 10 generated by the material scraper 3 is increased, so that the height of the first package adhesive line formed by the package adhesive in the first slit 10 is reduced, and finally the uniformity of the final height of the first package adhesive line and the final height of the second package adhesive line has been improved.

In an embodiment, a ratio of the width of each of the first slits 10 along the second direction to the width of each of the second slits 20 along the first direction ranges from 1.15:1 to 1.25:1.

The present disclosure has found through research that the resulting final width has a certain relationship with the final height under the same width of the slit. The greater the final width of the package adhesive line is, the lower the final height is. Conversely, the less the final width of the package adhesive line is, the higher the final height is. In addition, according to the different influences of the printing direction (the traveling direction of the material scraper 3) on the package adhesive lines manufactured according to the first slit group and the second slit group, the ratio of the width of each of the first slits 10 along the second direction to the width of each of the second slits 20 along the first direction is adjusted to be from 1.15:1 to 1.25:1, so as to finally offset the different influences of the printing direction on the package adhesive line according to the first slit group and the second slit group, so that the final width of the manufactured first package adhesive line is unified with the final width of the second package adhesive line, and the final height of the first package adhesive line is unified with the final height of the second package adhesive line. Therefore, the Newton's ring phenomenon occurs due to the inconsistency of the interval between the two substrates after the first package adhesive line and the second package adhesive line are packaged can be avoided.

In an embodiment, in addition, the width of each of the first slits 10 along the second direction ranges from 300 $\mu$m

to 700 μm, and the width of each of the second slits 20 along the first direction ranges from 240 μm to 609 μm.

By further configuring the width of each of the first slits 10 along the second direction from 300 μm to 700 μm and the width of each of the second slits 20 along the first direction from 240 μm to 609 μm, the final width of the first package adhesive line and the second package adhesive line can be made within a suitable range after printing, and the packaging requirements of the display panel can be satisfied, and the packaging effect can be further improved.

It should be noted that the width of the first slit 10 along the second direction and the width of the second slit 20 along the first direction are designed according to the product size and the size of the product frame, or are designed according to the packaging effect. Generally, the greater the width of the slit is, the greater the width of the corresponding sealant line is, and the better the sealing effect will be.

A second aspect of the present disclosure further provides a packaging method, a package area is provided by the aforementioned mask, forming a first package adhesive line corresponding to a first slit group, and forming a second package adhesive line corresponding to a second slit group. Since the aforementioned mask has the above technical effects, the packaging method using the above mask for packaging should also have the same technical effect, and will not be described in detail herein.

The packaging method includes the following steps of:

a first substrate is provided;
the aforementioned mask is disposed on the first substrate;
the package adhesive is coated in the first slit group and the second slit group of the mask; and
the material scraper 3 is traveled along the first direction on a surface of the mask, the package adhesive is pressed into the first slit group and the second slit group, and the excess package adhesive are scraped off.

In an embodiment, the used packaging material is glass cement. Optionally, the glass cement has a viscosity of 40,000 cps to 200,000 cps. By controlling the viscosity of the glass cement, the flowability of the glass cement is controlled to a certain extent to ensure that the final height of the package adhesive line is within the required range.

A third aspect of the present disclosure further provides a display panel, which is manufactured by the aforementioned packaging method. Since the aforementioned packaging method has the above technical effects, the display panel manufactured by the above packaging method should also have the same technical effect, and will not be described in detail herein.

In an embodiment, a uniformity between a height of the first package adhesive line and a height of the second package adhesive line is less than 5%. The display panel adopts the above packaging method, and can significantly improve the uniformity of the height of the first package adhesive line and the second package adhesive line, and reduce the uniformity of the height of the first package adhesive line and the second package adhesive line to 5%. The interval between the two substrates of the display panel obtained by packaging is equal, and the Newton ring due to the uneven interval can be avoided, thereby improving the quality of the display panel.

In an embodiment, the height of the first package adhesive line and the height of the second package adhesive line are 5.2 μm to 5.7 μm. It can meet the packaging requirements of the display panel and further improve the packaging effect.

Comparative example 1

A batch packaging production was carried out with a mask having a width of the first slit 10 along the second direction of 450 μm and a width of the second slit 20 along the first direction of 450 μm, and the obtained statistical data were shown in Table 1.

Example 1

A batch packaging production was carried out with a mask having a width of the first slit 10 along the second direction of 550 μm and a width of the second slit 20 along the first direction of 450 μm, and the obtained statistical data were shown in Table 2.

Table 1 Statistical data for batch products of Comparative Example 1

| Item | Width | | Height/Depth | |
|---|---|---|---|---|
| | First package adhesive line | Second package adhesive line | First package adhesive line | Second package adhesive line |
| Slit/μm | 450 | 450 | 5.80 | 5.80 |

(continued)

| Item | Width | | Height/Depth | |
|---|---|---|---|---|
| | First package adhesive line | Second package adhesive line | First package adhesive line | Second package adhesive line |
| Final value/$\mu$m | 464.5 | 506.3 | 5.80 | 5.32 |
| Deviation value/$\mu$m | 14.5 | 56.3 | 0.35 | 0.13 |
| Uniformity/% | 2.15 | 3.28 | 4.71 | 7.82 |

Table 2 Statistical data for batch products of Example 1

| Item | Width | | Height/Depth | |
|---|---|---|---|---|
| | First package adhesive line | Second package adhesive line | First package adhesive line | Second package adhesive line |
| Slit/$\mu$m | 550 | 450 | 5.80 | 5.80 |
| Final value/$\mu$m | 564.0 | 504.3 | 5.35 | 5.21 |
| Deviation value/$\mu$m | 14.0 | 54.3 | 0.1 | 0.24 |
| Uniformity/% | 1.35 | 4.72 | 5.38 | 5.71 |

It should be noted that, in Tables 1 and 2, the slits refer to the first slit 10 and the second slit 20 corresponding to the first package adhesive line and the second package adhesive line, respectively. The final value is an average of the final width/height of the batch products. The deviation value is a difference between the final value minus a predetermined value.

In the present disclosure, uniformity = (maximum value - minimum value) / (maximum value + minimum value), the maximum value refers to a maximum value of the final width/height in the batch products, and the minimum value refers to a minimum value of the final width/height in the batch products. By calculating the uniformity, it is possible to acknowledge the deviation of the final width/height of the package adhesive line from the predetermined width/height. The predetermined width is the width of the corresponding slit, and the predetermined height is the depth of the corresponding slit.

As can be seen from the analysis of the data measured in Tables 1 and 2, when the width of the first slit 10 of the mask along the second direction is same as the width of the second slit 20 along the first direction, the final width of the first package adhesive line and the second package adhesive line are different, and the deviation tendency of the final widths is also different. In addition, the final heights of the first package adhesive line and the second package adhesive line are different, and the deviation tendency of the final heights is also different. Moreover, the final widths of the first package adhesive line and the second package adhesive line have a certain relationship with the final heights thereof. The greater the final widths of the package adhesive line are, the lower the final heights are. Conversely, the less the final widths of the package adhesive line are, the higher the final heights are.

Furthermore, the present disclosure derives the width of the first slit 10 along the second direction and the width of the second slit 20 along the first direction based on the analysis of the final width and the final height of the first package adhesive line and the second package adhesive line.

Table 3 Calculation data of the cross-sectional area of the package adhesive line of the batch products

| Item | Comparative example 1 | | Example 1 | |
|---|---|---|---|---|
| | First package adhesive line | Second package adhesive line | First package adhesive line | Second package adhesive line |
| Width of slit/$\mu$m | 450 | 450 | 550 | 450 |
| Final width/$\mu$m | 464.5 | 506.3 | 564.0 | 504.3 |
| Final height/$\mu$m | 5.80 | 5.32 | 5.35 | 5.31 |
| Cross-sectional area of package adhesive line/$\mu$m$^2$ | 2694.1 | 2693.5 | 3017.4 | 2677.8 |

It should be noted that, in Table 3, the widths of the slits refer to the width of the first slit 10 corresponding to the first package adhesive line along the second direction and the width of the second slit 20 corresponding to the second package adhesive line along the first direction, respectively. The cross-sectional area of the adhesive line is a longitudinal cross-sectional area of the first package adhesive line along the second direction or a longitudinal cross-sectional area of the second package adhesive line along the first direction.

Referring to Table 3, and the calculation data of the cross-sectional area of the package adhesive line of the batch products, the actual longitudinal cross-sectional areas of the first package adhesive line of Comparative Example 1, the second package adhesive line of Comparative Example 1, the first package adhesive line of Example 1, and the second package adhesive line of Example 1 are assumed to be $V_1$, $V_2$, $V_3$, and $V_4$, respectively. The final widths thereof are $L_1$, $L_2$, $L_3$, and $L_4$, respectively, and the final heights thereof are $H_1$, $H_2$, $H_3$, and $H_4$, respectively. $V_1=L_1*H_1$, $V_2=L_2*H_2$, $V_3=L_3*H_3$, and $V_4=L_4*H_4$.

$$V_2=V_4, L_2=L_4, \text{ and } H_2=H_4.$$

The second package adhesive line of Comparative Example 1 and the second package adhesive line of Embodiment 1 are both package adhesive lines extending along the second direction perpendicular to the printing direction. The degree of deviation of the final width thereof with respect to the width of the second slit 20 along the first direction is uniform, and the resulting final width is also close.

Assuming $V_1=V_3$ and $L_1=L_3$, then $H_1=H_3$.

The first package adhesive line of Comparative Example 1 and the first package adhesive line of Embodiment 1 are both package adhesive lines extending along the first direction parallel to the printing direction. The degree of deviation of the final width thereof with respect to the width of the slit should also be same, and the resulting final width is also close.

Therefore, the widths of the slits corresponding to the mutually parallel package adhesive lines can be made same, so that the final widths and final heights of the two mutually parallel package adhesive lines are same.

When

$$V_2=V_1, L_1/L_2=H_2/H_1=0.917, \text{ that is, } L_1 \neq L_2, \text{ and } H_2 \neq H_1.$$

The first package adhesive line of Comparative Example 1 refers to the package adhesive line extending along the first direction parallel to the printing direction. The second package adhesive line refers to the package adhesive line extending along the second direction perpendicular to the printing direction. The width of the first slit 10 along the second direction corresponding to the above-mentioned first package adhesive line and the width of the second slit 20 along the first direction corresponding to the above-mentioned second package adhesive line are same. However, the final widths and final heights of the first package adhesive line and the second package adhesive line are different. The final width of the first package adhesive line is narrower than the final width of the second package adhesive line, and the final height of the first package adhesive line is higher than the final height of the second package adhesive line.

Therefore, if the final heights of the first package adhesive line and the second package adhesive line are to be same, according to the concept of the present disclosure, it is required to increase the final width of the first package adhesive line, that is, the width of the first slit 10 corresponding to the first package adhesive line along the second direction needs to be relatively increased.

When

$$H_4=H_3, V_3V_4=(H_3*L_3)/(H_4*L_{44})=V_3/V_4=L_3/L_4=564.0/504.3=1.19.$$

The first package adhesive line of Example 1 is the package adhesive line extending along the first direction parallel to the printing direction, the second package adhesive line of Example 1 is the package adhesive line extending along the second direction perpendicular to the printing direction. The width of the first slit 10 along the second direction and the width of the second slit 20 along the first direction respectively corresponding to the two are different. However, the final height of the resulting first package adhesive line is closer to that of the resulting second package adhesive line. Therefore, it is proved that if the final heights of the first package adhesive line and the second package adhesive line are to be same, the width of the corresponding first slit 10 along the second direction and the width of the second slit 20 along the first direction need to be adjusted accordingly.

In addition, by a large amount of data statistics, the present disclosure has found that the ratio of the width of the first slit 10 along the second direction to the width of the second slit 20 along the first direction is configured to be from 1.15:1 to 1.25:1, which can offset the different degrees of the pressure actions of the packaging material in the first slit 10 and the packaging material in the second slit 20 by the material scraper 3. Therefore, the uniformity of the final heights of the first package adhesive line and the second package adhesive line is high, preventing the generation of Newton's ring. In addition, the final height of the first package adhesive line is consistent with that of the second package adhesive line. The packaging effect would be improved, the sealing effect would be improved, and the water blocking and oxygen resistance effect would be improved. Moreover, the ratio of the width of the first slit 10 along the second direction to the width of the second slit 20 along the first direction is configured to be from 1.15:1 to 1.25:1, so that the final heights of the first package adhesive line and the second package adhesive line are 5.2 μm to 5.7 μm, thereby satisfying the sealing requirement.

Furthermore, the ratio of the width of the first slit 10 along the second direction to the width of the second slit 20 along the first direction is configured to be 1.2:1, so that the uniformity of the final heights of the first package adhesive line and the second package adhesive line can be further improved, and the final heights of the first package adhesive line and the second package adhesive line are controlled to be 5.3 μm to 5.6 μm.

Hereinafter, the technical effect of the uniformity of the actual height of the first package adhesive line and the second package adhesive line manufactured by the mask of the present disclosure is further verified by Example 2.

Example 2

A batch packaging production was carried out with a mask, the mask has a first slit group and a second slit group which are formed as an enclosed regular quadrangle, a width of the first slit 10 along the second direction of 550 μm, and a width of the second slit 20 along the first direction of 450 μm. The obtained statistical data were shown in Table 4.

Table 4 Statistical data for batch products of Example 2 of the present disclosure

| Item | Width | | Height/Depth | |
|---|---|---|---|---|
| | First package adhesive line | Second package adhesive line | First package adhesive line | Second package adhesive line |
| Slit/μm | 550 | 450 | 5.45 | 5.45 |
| Final value/μm | 574 | 493 | 5.37 | 5.43 |
| Deviation value/μm | 24 | 43 | 0.08 | 0.02 |
| Uniformity/% | 1.27 | 3.31 | 4.09 | 3.81 |

It should be noted that, in Table 4, the slits refer to the first slit 10 and the second slit 20 corresponding to the first package adhesive line and the second package adhesive line, respectively. The final value refers to an average of the final width/height of the batch products. The deviation value refers to a difference between the final value minus a predetermined value.

The statistical results in Table 4 further verify that, the uniformity of the final height of the package adhesive line provided by the mask of the present disclosure is improved, so that the interval between the two substrates of the display panel after packaging can be equal, the generation of Newton's ring is avoided, and the quality of the display panel is improved.

In the description of the present disclosure, the terms "first" and "second" are used for descriptive purposes only and are not to be construed as indicating or implying relative importance.

In addition, terms such as "upper", "lower", "left", "right", "intermediate" and "one" used in this specification are used also for convenience of description, and are not intended to limit the scope of the application. Changes or adjustments in their relative relationship are considered to be within the scope of this application if they are not materially altered.

**Claims**

1. A package mask, comprising:

   a main body, and
   a package slit group defined on the main body, the package slit group comprising a first slit group extending along a first direction and a second slit group extending along a second direction, the first slit group and the second slit group being in communication with each other and are formed as an enclosed regular quadrangle, the first slit group comprising at least two first slits (10) each for manufacturing a first package adhesive line, the second slit group comprising at least two second slits (20) each for manufacturing a second package adhesive line, **characterized in that** a width of each of the first slits (10) along the second direction is greater than a width of each of the second slits (20) along the first direction, wherein the first direction is the same as a printing direction in which a packaging material is printed onto the package mask.

2. The package mask according to claim 1, wherein a ratio of the width of each of the first slits (10) along the second direction to the width of each of the second slits (20) along the first direction ranges from 1.15:1 to 1.25:1.

3. The package mask according to claim 2, wherein the ratio of the width of each of the first slits (10) along the second direction to the width of each of the second slits (20) along the first direction is 1.2:1.

4. The package mask according to any one of claims 1-3, wherein the width of each of the first slits (10) along the second direction ranges from 300 $\mu$m to 700 $\mu$m, the width of each of the second slits (20) along the first direction ranges from 240 $\mu$m to 609 $\mu$m.

5. The package mask according to any one of claims 1-4, wherein a height of the first package adhesive line and a height of the second package adhesive line range from 5.2 $\mu$m to 5.7 $\mu$m.

6. The package mask according to claim 5, wherein the height of the first package adhesive line and the height of the second package adhesive line range from 5.3 $\mu$m to 5.6 $\mu$m.

7. A packaging method, **characterized by** comprising providing a package area by using a package mask of any one of claims 1 to 6, forming a first package adhesive line corresponding to the first slit group, and forming a second package adhesive line corresponding to the second slit group; wherein the forming the first package adhesive line corresponding to the first slit group and the forming the second package adhesive line corresponding to the second slit group comprises:

   providing a first substrate;
   disposing the package mask on the first substrate;
   coating a package adhesive in the first slit group and the second slit group; and
   operating a material scraper (3) along the first direction on a surface of the mask to remove an excess package adhesive.

8. A display panel manufactured by using a packaging method of claim 7.

9. The display panel according to claim 8, wherein a uniformity between a height of a first package adhesive line and a height of a second package adhesive line is less than 5%.

10. The display panel according to claim 8 or 9, wherein a height of the first package adhesive line and a height of the second package adhesive line range from 5.2 $\mu$m to 5.7 $\mu$m.

11. The display panel according to claim 10, wherein the height of the first package adhesive line and the height of the second package adhesive line range from 5.3 $\mu$m to 5.6 $\mu$m.


**Patentansprüche**

1. Packungsmaske, umfassend:

   einen Hauptkörper und
   eine Packungsschlitzgruppe, die auf dem Hauptkörper definiert ist, die Packungsschlitzgruppe umfassend eine erste Schlitzgruppe, die sich entlang einer ersten Richtung erstreckt, und eine zweite Schlitzgruppe, die sich entlang einer zweiten Richtung erstreckt, wobei die erste Schlitzgruppe und die zweite Schlitzgruppe miteinander in Verbindung stehen und als geschlossenes regelmäßiges Viereck ausgebildet sind, die erste Schlitzgruppe umfassend mindestens zwei erste Schlitze (10), jeweils zum Herstellen einer ersten Packungsklebelinie, die zweite Schlitzgruppe umfassend mindestens zwei zweite Schlitze (20), jeweils zum Herstellen einer zweiten Packungsklebelinie, **dadurch gekennzeichnet, dass** eine Breite jedes der ersten Schlitze (10) entlang der zweiten Richtung größer als eine Breite jedes der zweiten Schlitze (20) entlang der ersten Richtung ist, wobei die erste Richtung dieselbe wie eine Druckrichtung ist, in der ein Verpackungsmaterial auf die Packungsmaske gedruckt wird.

**2.** Packungsmaske nach Anspruch 1, wobei ein Verhältnis der Breite von jedem der ersten Schlitze (10) entlang der zweiten Richtung zu der Breite von jedem der zweiten Schlitze (20) entlang der ersten Richtung in dem Bereich von 1,15:1 bis 1,25:1 liegt.

**3.** Packungsmaske nach Anspruch 2, wobei das Verhältnis der Breite von jedem der ersten Schlitze (10) entlang der zweiten Richtung zu der Breite von jedem der zweiten Schlitze (20) entlang der ersten Richtung 1,2:1 beträgt.

**4.** Packungsmaske nach einem der Ansprüche 1 bis 3, wobei die Breite von jedem der ersten Schlitze (10) entlang der zweiten Richtung in dem Bereich von 300 $\mu$m bis 700 $\mu$m liegt und die Breite von jedem der zweiten Schlitze (20) entlang der ersten Richtung in dem Bereich von 240 $\mu$m bis 609 $\mu$m liegt.

**5.** Packungsmaske nach einem der Ansprüche 1 bis 4, wobei eine Höhe der ersten Packungsklebelinie und eine Höhe der zweiten Packungsklebelinie in dem Bereich von 5,2 $\mu$m bis 5,7 $\mu$m liegen.

**6.** Packungsmaske nach Anspruch 5, wobei die Höhe der ersten Packungsklebelinie und die Höhe der zweiten Packungsklebelinie in dem Bereich von 5,3 $\mu$m bis 5,6 $\mu$m liegen.

**7.** Verpackungsverfahren, **gekennzeichnet durch** das Umfassen eines Bereitstellens eines Packungsbereichs durch Verwenden einer Packungsmaske nach einem der Ansprüche 1 bis 6, wobei eine erste Packungsklebelinie entsprechend der ersten Schlitzgruppe ausgebildet wird und wobei eine zweite Packungsklebelinie ausgebildet wird, entsprechend der zweiten Schlitzgruppe;

> wobei das Ausbilden der ersten Packungsklebelinie, die der ersten Schlitzgruppe entspricht, und das Ausbilden der zweiten Packungsklebelinie, die der zweiten Schlitzgruppe entspricht, umfasst: Bereitstellen eines ersten Substrats;
> Anordnen der Packungsmaske auf dem ersten Substrat;
> Auftragen eines Packungsklebstoffs in die erste Schlitzgruppe und die zweite Schlitzgruppe; und
> Betätigen eines Materialschabers (3) entlang der ersten Richtung auf einer Oberfläche der Maske, um überschüssigen Packungsklebstoff zu entfernen.

**8.** Anzeigetafel, die durch Verwenden eines Verpackungsverfahrens nach Anspruch 7 hergestellt wird.

**9.** Anzeigetafel nach Anspruch 8, wobei eine Gleichmäßigkeit zwischen einer Höhe einer ersten Packungsklebelinie und einer Höhe einer zweiten Packungsklebelinie weniger als 5 % beträgt.

**10.** Anzeigetafel nach Anspruch 8 oder 9, wobei eine Höhe der ersten Packungsklebelinie und eine Höhe der zweiten Packungsklebelinie in dem Bereich von 5,2 $\mu$m bis 5,7 $\mu$m liegen.

**11.** Anzeigetafel nach Anspruch 10, wobei die Höhe der ersten Packungsklebelinie und die Höhe der zweiten Packungsklebelinie in dem Bereich von 5,3 $\mu$m bis 5,6 $\mu$m liegen.

**Revendications**

**1.** Masque d'emballage, comprenant :

> un corps principal, et
> un groupe de fentes d'emballage défini sur le corps principal, le groupe de fentes d'emballage comprenant un premier groupe de fentes s'étendant le long d'un premier sens et un second groupe de fentes s'étendant le long d'un second sens, le premier groupe de fentes et le second groupe de fentes étant en communication l'un avec l'autre et sont formés en tant que quadrilatère régulier fermé, le premier groupe de fentes comprenant au moins deux premières fentes (10) chacune permettant de fabriquer une première ligne adhésive d'emballage, le second groupe de fentes comprenant au moins deux secondes fentes (20) chacune permettant de fabriquer une seconde ligne adhésive d'emballage, **caractérisé en ce qu'**une largeur de chacune des premières fentes (10) le long du second sens est supérieure à une largeur de chacune des secondes fentes (20) le long du premier sens, dans lequel le premier sens est le même qu'un sens d'impression dans lequel un matériau d'emballage est imprimé sur le masque d'emballage.

**2.** Masque d'emballage selon la revendication 1, dans lequel un rapport entre la largeur de chacune des premières fentes (10) le long du second sens et la largeur de chacune des secondes fentes (20) le long du premier sens est compris entre 1,15:1 et 1,25:1.

**3.** Masque d'emballage selon la revendication 2, dans lequel le rapport entre la largeur de chacune des premières fentes (10) le long du second sens et la largeur de chacune des secondes fentes (20) le long du premier sens est de 1,2:1.

**4.** Masque d'emballage selon l'une quelconque des revendications 1 à 3, dans lequel la largeur de chacune des premières fentes (10) le long du second sens est comprise entre 300 $\mu$m et 700 $\mu$m, la largeur de chacune des secondes fentes (20) le long du premier sens est comprise entre 240 $\mu$m et 609 $\mu$m.

**5.** Masque d'emballage selon l'une quelconque des revendications 1 à 4, dans lequel une hauteur de la première ligne adhésive d'emballage et une hauteur de la seconde ligne adhésive d'emballage sont comprises dans la plage allant de 5,2 $\mu$m à 5,7 $\mu$m.

**6.** Masque d'emballage selon la revendication 5, dans lequel la hauteur de la première ligne adhésive d'emballage et la hauteur de la seconde ligne adhésive d'emballage sont comprises dans la plage allant de 5,3 $\mu$m à 5,6 $\mu$m.

**7.** Procédé d'emballage, **caractérisé par le fait qu'**il comprend la fourniture d'une zone d'emballage en utilisant un masque d'emballage selon l'une quelconque des revendications 1 à 6, la formation d'une première ligne adhésive d'emballage correspondant au premier groupe de fentes, et la formation d'une seconde ligne adhésive d'emballage correspondant au second groupe de fentes ;
dans lequel la formation de la première ligne adhésive d'emballage correspondant au premier groupe de fentes et la formation de la seconde ligne adhésive d'emballage correspondant au second groupe de fentes comprend :

la fourniture d'un premier substrat ;
la disposition du masque d'emballage sur le premier substrat ;
le revêtement d'un adhésif d'emballage dans le premier groupe de fentes et le second groupe de fentes ; et
l'exploitation d'un racleur de matériau (3) le long du premier sens sur une surface du masque pour enlever un excès d'adhésif d'emballage.

**8.** Panneau d'affichage fabriqué en utilisant un procédé d'emballage selon la revendication 7.

**9.** Panneau d'affichage selon la revendication 8, dans lequel une uniformité entre une hauteur d'une première ligne adhésive d'emballage et une hauteur d'une seconde ligne adhésive d'emballage est inférieure à 5 %.

**10.** Panneau d'affichage selon la revendication 8 ou 9, dans lequel une hauteur de la première ligne adhésive d'emballage et une hauteur de la seconde ligne adhésive d'emballage sont comprises dans une plage allant de 5,2 $\mu$m à 5,7 $\mu$m.

**11.** Panneau d'affichage selon la revendication 10, dans lequel la hauteur de la première ligne adhésive d'emballage et la hauteur de la seconde ligne adhésive d'emballage sont comprises dans une plage allant de 5,3 $\mu$m à 5,6 $\mu$m.

**FIG. 1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2011128493 A1
- CN 106494066

- US 20150131044 A1